(19) Europäisches Patentamt
European Patent Office
Office européen des brevets

(11) **EP 2 680 022 B1**

(12) **EUROPEAN PATENT SPECIFICATION**

(45) Date of publication and mention of the grant of the patent:
**06.12.2017 Bulletin 2017/49**

(51) Int Cl.:
***G01R 33/34*** $^{(2006.01)}$ ***G01R 33/343*** $^{(2006.01)}$

(21) Application number: **13174124.1**

(22) Date of filing: **27.06.2013**

(54) **Radiofrequency coil for measurement of nuclear magnetic resonance**

RF-Spule zur Messung von kernmagnetischer Resonanz

Bobine de radiofréquence pour mesurer la résonance magnétique nucléaire

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.06.2012 JP 2012148036**

(43) Date of publication of application:
**01.01.2014 Bulletin 2014/01**

(73) Proprietor: **RIKEN**
**Wako-shi, Saitama 351-0198 (JP)**

(72) Inventor: **Takahashi, Masato**
**Saitama 351-0198 (JP)**

(74) Representative: **Vigand, Philippe et al**
**Novagraaf International SA**
**Chemin de l'Echo 3**
**1213 Onex - Genève (CH)**

(56) References cited:
**JP-A- H02 195 938**
**JP-U- S61 166 507**
**US-A- 4 641 097**
**US-A- 4 875 013**
**US-A- 6 121 776**
**US-A1- 2001 033 166**
**US-A1- 2006 158 188**
**US-B1- 7 106 063**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 680 022 B1

## Description

[TECHNICAL FIELD]

The present invention relates to an RF coil used to excite or detect nuclear magnetic resonance.

[BACKGROUND ART]

NMR (nuclear magnetic resonance) apparatuses and MRI (magnetic resonance imaging) apparatuses have been developed as apparatuses utilizing nuclear magnetic resonance. When a nucleus is placed in a magnetic field, an energy state thereof is split into a plurality of energy levels by Zeeman splitting. Giving an energy equal to the difference in these energy levels (determined by frequency) as electromagnetic waves will cause absorption and emission of energy. This phenomenon is the nuclear magnetic resonance. NMR apparatuses and MRI apparatuses are widely used not only in the fields of physics and chemistry but also in other various fields, such as biology, medical sciences, pharmaceutical sciences, agricultural sciences, material sciences, and chemical engineering. For instance, they are used in structure determination and identification in organic chemistry, analysis of protein structure and intermolecular interactions, and medical MRI.

Such apparatuses can measure a subtle frequency difference due to a magnetic environment around atoms of the same isotope in a sample and relaxation in nuclear magnetic resonance. Such measurement can provide information about a chemical shift, signal intensity (quantitative determination), relaxation time, spin coupling, and NOE (nuclear Overhauser effect). Such information enables determination of the molecular structure, intermolecular interaction, and mobility. These apparatuses are advantageous in that they can perform atomic-level measurement noninvasively. On the other hand, they suffer from a problem of low measurement signal intensities (low sensitivities). This is because the numbers of atoms in which the respective energy levels are occupied follow the Boltzmann distribution and the energy difference resulting from Zeeman splitting is very small.

Because the signal intensity is proportional to the 3/2 power of the magnetic field intensity, development of NMR apparatuses and MRI apparatuses focusing on the enhancement of the magnetic field intensity has been performed. At the present day, a strong magnetic field as high as or higher than 23.5 T (i.e. 1 GHz in the resonance frequency of $^{1}$H) is required in the measurement of residual magnetic dipole-dipole interaction, TROSY effect, and measurement of quadrupolar nuclei. Thus, it is expected that the magnetic field intensity will be increasing in the future with development of superconducting magnets.

To cause nuclear magnetic resonance, an antenna (or RF coil) that transmits and receives a signal of a nuclear magnetic resonance frequency in a direction perpendicular to the direction of static magnetic field generated by a superconducting magnet is needed. A high frequency signal is transmitted to the RF coil from a power amplifier to apply a high frequency magnetic field ($B_1$ magnetic field) to a sample to be measured, thereby creating an excited state in it. Then, an NMR signal emitted from the measurement sample is received by the RF coil.

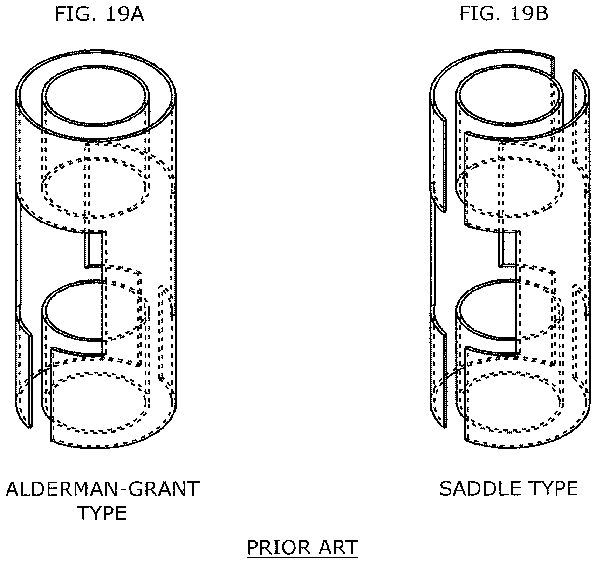

RF coils shown in Figs. 19A and 19B are known as conventional RF coils used in NMR apparatuses and MRI apparatuses. The coil shown in Fig. 19A is described in, for example, non-patent document 1 and called an Alderman-Grant type coil. The coil shown in Fig. 19B is described in, for example, non-patent document 2 and called a saddle type coil. The number of turns of these coils is one. This is because an increase in the number of turns of an RF coil leads to a decrease in the self resonance frequency, making it impossible to be used as an RF coil at high frequencies.

The self resonance frequency is the highest value of frequencies at which a coil can behave as a coil. A coil inherently has a stray capacitance, and parallel resonance occurs between the inductance and the stray capacitance, leading to self resonance. At frequencies higher than the self resonance frequency, a coil does not function as a coil but a capacitor.

[PRIOR ART DOCUMENTS]

Non-patent Document 1: Alderman DW, Grant DM. "Efficient Decoupler Coil Design which Reduces Heating in Conductive Samples in Superconducting Spectrometers", Journal of Magnetic Resonance, 1979;36:447-451.

Non-Patent Document 2: Gerald J. Kost, et. al., "A Cylindrical-Window NMR Probe with Extended Tuning Range for Studies of the Developing Heart", Journal of Magnetic Resonance, 1989;82:238-252. Further prior art RF coils are disclosed in the documents US 4,641,097 (this document discloses an RF coil according to the preamble of claim 1), US 2006/158188, JP S61 166507, US 7,106,063, US 2001/033166, US 6,121,776, JP H02 195938 and US 5,245,285.

[SUMMARY OF THE INVENTION]

[PROBLEMS TO BE SOLVED BY THE INVENTION]

In an NMR apparatus using a resonance frequency of 900 MHz, an RF coil having a shape shown in Fig. 19A or 19B is used. The self resonance frequency of such an RF coil is approximately in the range of 900 MHz to 1 GHz. In cases where the nuclear magnetic resonance frequency exceeds 1 GHz (corresponding to a static magnetic field intensity of 23.5 T), an RF coil intended for use in an apparatus using a resonance frequency of 900 MHz cannot be used without modification. Therefore, it is necessary to increase the self resonance frequency of the RF coil to a frequency higher than the self resonance frequencies of conventional RF coils.

The increase in the self resonance frequency of the RF coil is required not only in NMR apparatuses with nuclear resonance frequencies higher than 1 GHz. The self resonance frequency of an RF coil is determined by the size of the RF coil and other factors. Therefore, in NMR apparatuses and MRI apparatuses using resonance frequencies lower than 1 GHz also, the limit of self resonance frequency will be reached eventually as the nuclear resonance frequency is increased with increases in the magnetic field intensity.

The simplest method of increasing the self resonance frequency is to reduce the diameter of the RF coil and/or a measurement sample. However, this undesirably leads to a decrease in the measurement sensitivity. Another method is to increase the distance between a vertical band part and a guard ring. However, in this method, although the self resonance frequency increases with a decrease in a capacitance component, the diameter of the coil becomes larger with the diameter of the measurement sample space being unchanged, resulting in an increased distance between the coil and the measurement sample. Moreover, the volume of the space that is irradiated with the high frequency magnetic field but not occupied by the measurement sample will also become larger, leading to a decrease in the efficiency of the RF coil, namely deterioration in the performance of the RF coil.

In view of the above-described problems, an object of the present invention is to provide an RF coil for use in measurement of nuclear magnetic resonance that has a self resonance frequency higher than those of conventional RF coils and does not cause a decrease in the measurement sensitivity.

[Means for Solving the Problems]

An RF coil according to the present invention is an RF coil used to induce or detect nuclear magnetic resonance as defined in the appended claims.

In the above-described RF coil, it is preferred that said two guard rings be divided at a position facing said separate wing part.

It is also preferred that said separate wing part be provided at a position farther from said guard rings than the positions of said first and second vertical band parts.

It is also preferred that the length of said first and second vertical band parts along the axial direction be shorter than the distance between the upper end and the lower end of said two guard rings, so that the guard rings have an upper end portion or lower end portion that does not face said first or second vertical band part.

It is also preferred that a connecting portion that connects said separate wing part be provided around the upper end portion or lower end portion of the guard rings that does not face said first or second vertical band part, at a position facing the outer circumferential surface of said guard rings.

By employing the above configuration, the capacitance can be reduced without a decrease in the inductance of the RF coil or an increase in the distance between the sample and the RF coil.

In the RF coil according to the present invention, it is preferred that the distances between the first and second vertical band parts and said guard rings be larger in an end region.

In the RF coil according to the present invention, said first and second vertical band parts may have arc shapes (including circular arc shapes and elliptic circular arc shapes) in cross section perpendicular to the axis. Alternatively they may have plate-like shapes or shapes constituted by a plurality of flat plates joined together.

In the RF coil according to the present invention, the first and second vertical band parts may have a slit provided in a portion not facing the circumferential surface of said guard rings.

[ADVANTAGEOUS EFFECT OF THE INVENTION]

According to the present invention, there can be provided an RF coil used to measure nuclear magnetic resonance having a self resonance frequency higher than those of conventional RF coils.

[BRIEF DESCRIPTION OF THE DRAWINGS]

Figs. 1A and 1B are diagrams showing the shapes of RF coils according to a first example.

Fig. 2 shows a result of simulation (Smith chart) representing characteristics of an RF coil according to the first example.

Figs. 3A to 3C are diagrams showing the shapes of RF coils according to a first embodiment.

Fig. 4 shows a result of simulation (Smith chart) representing characteristics of an RF coil according to the first embodiment.

Figs. 5A and 5B are diagrams showing the shapes of RF coils according to modifications of the first embodiment.

Figs. 6A to 6C are diagrams showing the shapes of RF coils according to a further example.

Fig. 6D is a diagram showing the shape of an RF coil according to a modification.

Fig. 7 shows a result of simulation (Smith chart) representing characteristics of an RF coil according to the further example.

Figs. 8A to 8C are diagrams showing the shapes of RF coils according to modifications.

Figs. 9A to 9C are diagrams showing the shapes of RF coils according to modifications.

Figs. 10A and 10B are diagrams showing the shapes of RF coils according to modifications.

Figs. 11A to 11C are diagrams showing the shapes of RF coils according to modifications.

Figs. 12A and 12B are diagrams showing the shapes of RF coils according to modifications.

Figs. 13A to 13C are diagrams showing the shapes of RF coils according to modifications.

Figs. 14A to 14C are diagrams showing the shapes of RF coils according to modifications.

Figs. 15A to 15C are diagrams showing the shapes of RF coils according to modifications.

Figs. 16A and 16B are diagrams showing the shapes of RF coils according to modifications.

Figs. 17A to 17D are diagrams showing the shapes of RF coils according to modifications.

Figs 18A and 18B are diagrams illustrating the basic structure of an NMR apparatus.

Figs. 19A and 19B are diagrams showing the shapes of RF coils according to prior arts.

Fig. 20 is an equivalent circuit diagram of an RF coil.

[EMBODIMENTS FOR CARRYING OUT THE INVENTION AND EXAMPLES NOT FORMING EMBODIMENTS OF THE PRESENT INVENTION]

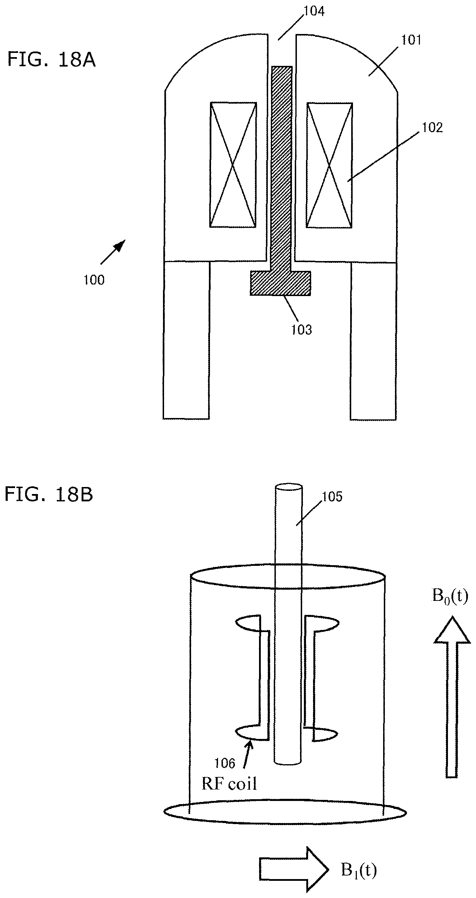

Fig. 18A is a diagram showing the basic construction of an NMR apparatus. A main coil 102 made of a superconducting wire is wound inside a superconducting magnet 101. The main coil 102 is typically disposed in an insulating container (not shown) that can contain liquid helium or the like so as to be cooled to a temperature equal to or lower than the phase transition temperature. An NMR probe 103 is composed of a base part disposed outside the magnet and a cylindrical part inserted inside the magnet. The cylindrical part is typically inserted into a cylindrical bore 104 passing through the superconducting magnet 101 along its center axis upwardly from the lower opening.

Fig. 18B is a diagram showing the inner structure of the NMR probe 103. A sample tube containing a sample solution to be measured is inserted into the NMR probe 103 from above. The NMR probe 103 has an RF coil 106, which is built therein to apply a magnetic field $B_1$ oriented perpendicular to a static magnetic field $B_0$ generated by the superconducting magnet 101. The RF coil 106 applies a high frequency magnetic field $B_1$ to a sample to induce nuclear magnetic resonance and detect (or receive) electromagnetic waves (NMR signal) generated with relaxation. The diameter of a standard sample tube is 5 mm, and the diameter of the RF coil 106 is larger than 5 mm accordingly. Typically, the smallest inner diameter of the RF coil is in the range of 5.4 mm to 10 mm. The frequency of the magnetic field in the lateral direction generated by the RF coil 106 is proportional to the intensity of the static magnetic field. For instance, when the intensity of the static magnetic is 24.2 T, a magnetic field having a frequency of 1.03 GHz is needed.

To generate a high frequency magnetic field, it is necessary for the RF coil 106 to have a self resonance frequency higher than the frequency of the high frequency magnetic field. The self resonance frequency is the highest value of frequencies at which a coil can behave as a coil. A coil has a stray capacitance, and parallel resonance occurs between the inductance and the stray capacitance, leading to self resonance. The self resonance frequency of the RF coil 106 is expressed by the following equation:

$$f = \frac{1}{2\pi\sqrt{LC}},$$

where L is the inductance of the coil, and C is the capacitance of the coil.

A possible solution for increasing the self resonance frequency is to decrease the inductance L by reducing the size of the RF coil and/or decreasing the number of turns thereof. Reducing the size of the RF coil will make conventional 5-mm sample tubes unusable. The number of turns of the RF coil is one, which cannot be decreased further. Even if the self resonance frequency is increased by a reduction in the size of the RF coil, a decrease in the volume of the sample is necessitated, leading to deterioration in the measurement sensitivity.

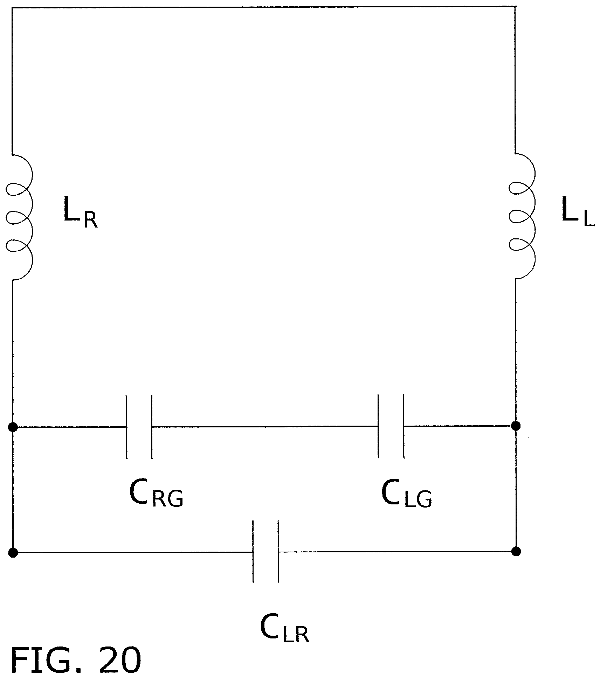

For the above reason, it is necessary for a solution for increasing the self resonance frequency to decrease the capacitance without changing the size of the RF coil. Capacitance components of the Alderman-Grant coil shown in Fig. 19A include a capacitance in opposed wing portions of vertical band parts, a capacitance between the vertical band parts and guard rings, and a stray capacitance between the RF coil and a metal part(s) around it. The equivalent circuit of the Alderman-Grant coil is shown in Fig. 20. As shown in Fig. 20, the capacitance $C_{LR}$ of the opposed wing portions of the vertical band parts and the capacitance between the vertical band parts and the guard rings are connected in parallel between two inductances $L_R$ and $L_L$. The capacitance between the vertical band parts and the guard rings is constituted by a capacitance $C_{LG}$ between one vertical band part and the guard rings and a capacitance $C_{RG}$ between the other vertical band part and the guard rings that are connected in series. To increase the self resonance frequency of the RF coil, it is necessary to reduce at least one of these capacitances $C_{LR}$, $C_{RG}$, and $C_{LC}$.

Another possible method is to increase the distance between the vertical band parts and the guard rings so as to reduce the capacitance generated between the vertical band parts and the guard rings. However, this results in an increase in the distance between the coil and the measurement sample and an increase in the volume of the space that is irradiated with the high frequency magnetic field but not occupied by the measurement sample, leading to a decrease in the efficiency of the RF coil. Therefore, in the present invention, a capacitance component(s) of the RF coil is (are) decreased by a method different from the above-described method.

In the following, specific examples not forming embodiments of the present invention and embodiments of the RF coil having an increased self resonance frequency without deterioration in the performance will be described.

<First Example : Straight Type>

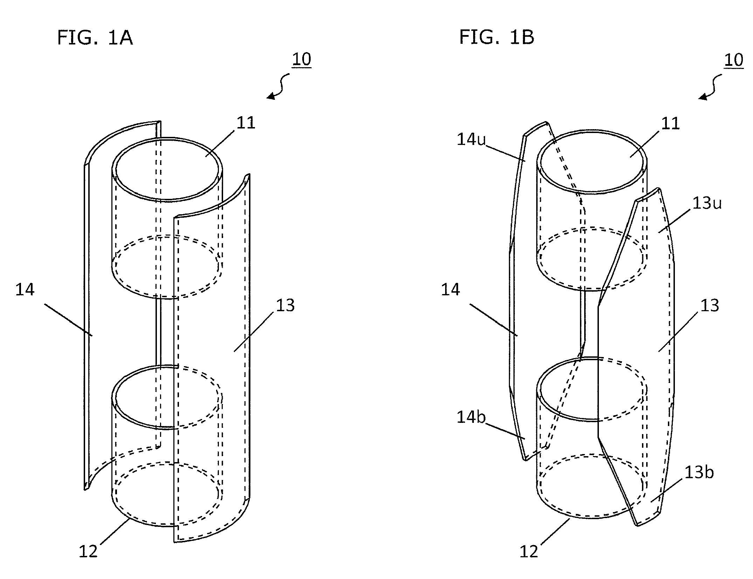

Fig. 1A shows the outer appearance of an RF coil. In this example, the wing portions of the Alderman-Grant coil are removed, so that the areas where the vertical band parts and the guard rings face each other are decreased, leading to decrease in the capacitance. The RF coil according to this example will be referred to as a straight type coil in this specification.

The RF coil 10 according to this example is basically composed of an upper guide ring 11, a lower guide ring 12, and two vertical band parts 13, 14. In this specification, the up-down direction refers to the direction of static magnetic field generated by the super conducting magnet 101, namely the vertical direction in the case of an NMR apparatus like that shown in Figs. 18A and 18B. The left-right direction refers to a direction perpendicular to the direction of the static magnetic field. However, in some NMR apparatuses (or MRI apparatuses), the static magnetic field is oriented in a direction different from the vertical direction (e.g. in a horizontal direction). In such cases, the terms used in this specification concerning directions should be construed accordingly.

The guard rings 11, 12 are cylindrical (including elliptic cylindrical) in shape and arranged coaxially with a space therebetween along the axis of the cylinders. The vertical band parts 13, 14 are arranged outside the guard rings 11, 12 and extending in the up-down direction. The vertical band parts 13, 14 are arranged outside the guard rings 11, 12 and opposed to each other. In this embodiment, the vertical band parts 13, 14 have circular arc shapes (including elliptic arc shapes) in their horizontal cross sections running along the outer circumference of the guard rings 11, 12. In this embodiment, the upper ends of the vertical band parts 13, 14 and the upper end of the upper guard ring 11 are at the same level, and the lower ends of the vertical band parts 13, 14 and the lower end of the lower guard ring 12 are at the same level. However, it is not essential for the ends of the vertical band parts 13, 14 and the ends of the guard rings to be at the same level, but they may be at different levels.

A cylindrical dielectric member (not shown) such as a quartz tube is provided between the vertical band parts 13, 14 and the guard rings 11, 12. This member is provided only for the purpose of maintaining the shape of the RF coil, and it is not essential as an electromagnetic component. Therefore, if the RF coil is rigid enough to be able to keep its shape independently, the cylindrical dielectric member may be eliminated.

Power supply to the coil may be provided in any suitable manner. For example, power may be supplied through the vertical band parts and the guard rings, through the two vertical band parts, or through the two guard rings.

In this example, the edges of the vertical band parts 13, 14 with respect to the circumferential direction are straight. In this respect, the coil differs from the Alderman-Grant coil, in which the vertical band parts have wing portions provided near the guard rings. While the axial end portions of the vertical band parts in this example may be tapered, it is preferred that the vertical band parts be straight in the axial region in which the guard rings do not exist. This region will be hereinafter referred to as the "window", in this specification.

With this configuration, the areas where the vertical band parts and the guard rings face each other are decreased, and the capacitance is decreased accordingly. Therefore, the self resonance frequency can be increased. On the other hand, the coil size and the inductance are not decreased. Therefore, the measurement sensitivity is not lowered. A further advantage is that since the edges, through which current flows, are not angled in the window region, no loss occurs. A still further advantage is that the shape of the RF coil is simple, so that it tends not to disturb the evenness of the static magnetic field ($B_0$). A sill further advantage is that manufacturing of the coil is easy thanks to its simple shape.

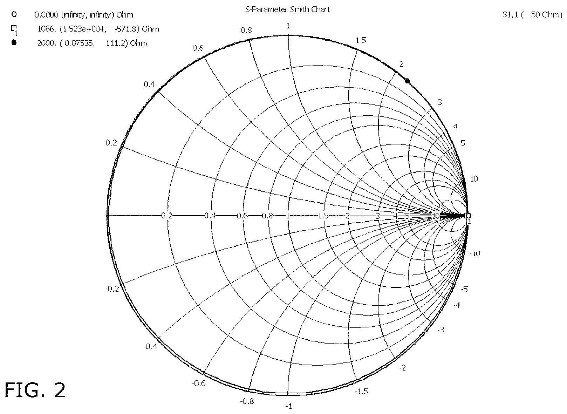

Fig. 2 shows the result of analysis of characteristics of the RF coil according to this example performed by simulation. Fig. 2 is a chart called a Smith chart, which shows complex impedances at different frequencies in a case where a power supply port is attached to the RF coil.

First, the simulation method used will be described. In the simulation, transient response analysis was carried out using three-dimensional high frequency electromagnetic field simulation software MICOWAVE STUDIO developed by CST. Two short wires were attached to the two vertical bands of the RF coil respectively, and a balanced power supply port matched to 50 ohms was attached to connect the free ends of the two wires. In this analysis, high frequency pulses are input from the power supply port, and the response of the RF coil thereto is computed using the FDTD method, which is a time-domain electromagnetic field analysis method. The result in the frequency domain can be obtained by Fourier-transforming the pulse input and the result in the time domain. Results that can be obtained include magnetic field distributions, electric field distributions, and current distributions at respective frequencies in the object of the analysis, storage and loss of energy caused by them, and complex impedances at respective frequencies (Smith chart) as response for the power supply port. The self resonance frequency of the RF coil can be determined by analyzing the Smith chart thus obtained . It is also possible to evaluate the performance of the RF coil using the above-described results in combination.

In cases where results of simulation and values obtained by measurement performed on the RF coil actually made are to be compared, the dimensions of the gaps between the vertical band parts and the cylindrical dielectric part such as the quartz tube and between the cylindrical dielectric part such as the quartz tube and the guard rings (typically less than 0.1 mm) may be taken into account in the simulation to improve accuracy of analysis. However, this leads to a vast number of computational meshes and long computation time. For this reason such computation is not performed in typical cases. In terms of relative values such as a change in the self resonance frequency depending on the shape of the RF coil, there is no significant difference between a value obtained by simulation taking into account the dimensions of gaps and a value obtained by simulation not taking into account them. Therefore, simulation not taking into account the dimensions of gaps can provide computation with high accuracy, and the results are reliable. When the RF coil is used in an NMR apparatus or an MRI apparatus, the resonance frequency of the RF coil varies depending on the measurement sample. A typical countermeasure against this is the use of a trimmer capacitor for adjustment connected to the RF coil. Providing the trimmer capacitor for adjustment increases the capacitance, leading to a lowering of the resonance frequency. Therefore, in the actual design, analysis, and manufacturing of the RF coil, it is necessary to take them into account in determining the resonance frequency of the RF coil.

In the Smith chart, the complex impedance at each frequency is represented by a point. As the frequency becomes higher, the point typically shifts clockwise. If the point representing the complex impedance of a certain device at a certain frequency exists in the upper half of the Smith chart, the device will behave as an inductance at this frequency. If the point exists in the lower half of the Smith chart, the device will behave as a capacitance.

In the case of an actual device or simulation for analyzing it, the complex impedance may change in a complicated manner, and the point on the Smith chart may revolve plural times with increasing frequency in some cases. This indicates that the device has various magnetic fields, electric fields, and current distributions (modes) that vary from one frequency range to another. This is also the case with the RF coil. The mode in which the RF coil can generate a high frequency magnetic field in a direction perpendicular to the static magnetic field is the first mode, namely in the lowest frequency range among the frequency ranges existing in the upper half of the Smith chart. Therefore, the self resonance frequency, which represents the limit of usability as an RF coil, is a frequency corresponding to the point that passes the rightmost point of the Smith chart downward earliest among the points representing complex impedances that revolve clockwise on the Smith chart with increasing frequency.

From another viewpoint, the RF coil of this embodiment can be regarded as a parallel resonance circuit of inductance (L) and capacitance (C). The complex impedance of the LC parallel resonance circuit is infinite at the resonance frequency, and it is located at the rightmost point of the Smith chart.

The self resonance frequency of an RF coil according to this example designed for use with an NMR sample tube having a diameter of 5 mm was computed by the above-described method. The result was 1066 MHz. On the other hand, in the case of a conventional Alderman-Grant RF coil with two separated vertical bands having the same diameter design, the self resonance frequency obtained as the result was 842 MHz. Therefore, it was verified that the self resonance frequency was increased greatly by 224 MHz and that the RF coil according to the example can be used at higher frequencies.

<Modification of First Example>

In the above-described first example, the vertical band parts have straight shapes. The vertical band parts may have tapered shapes (normal tapered shapes) with their widths becoming smaller toward the ends in their end portions 13u, 13b, 14u, 14b with respect to the axial direction. As shown in Fig. 1B, the vertical band parts may be straight in the window region in which the guard rings are not exist and tapered in the region in which the guard rings exist. Alternatively, tapering may be beginning from the window region. It is preferred that the vertical band parts have rounded shapes without angled sharp edges in their end portions. Not having angled edges can lead to reduced loss. The tapered shapes allow a further reduction of the areas where the vertical band parts and the guard rings face each other, leading to a further reduction of the capacitance.

<First Embodiment: Separate Wing Type>

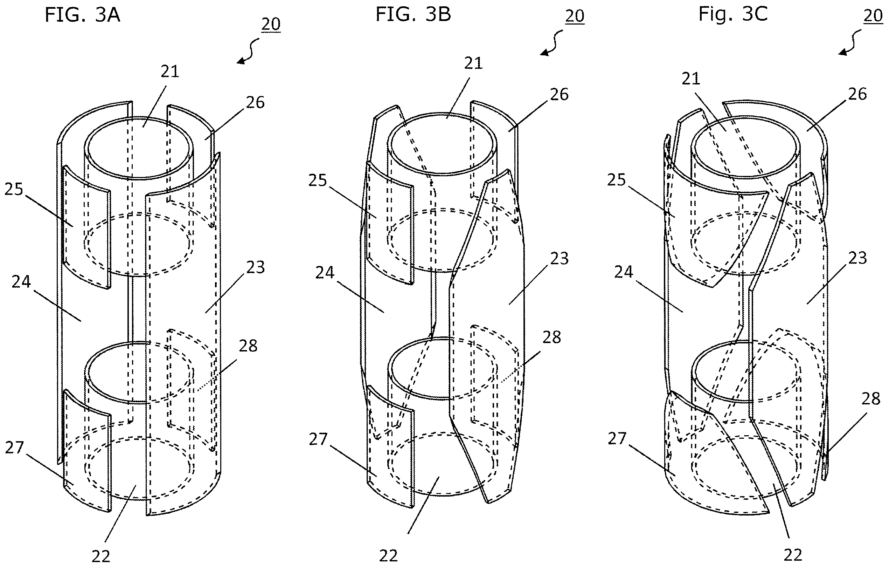

Fig. 3A shows the outer appearance of an RF coil according to the first embodiment. In this embodiment, the structure of the RF coil according to the first example is augmented to have separate wing parts 25 to 28 that are provided separately from the vertical band parts at positions facing the circumferential surfaces of the guard rings 21, 22 between the two vertical band parts 23, 24. The structure other than this is the same as that of the first example. The RF coil according to this embodiment will be referred to as the separate-wing type RF coil in this specification.

In the combined capacitance between the two vertical band parts, the capacitance independent from the guard rings is attributed to only one capacitor formed between the wing portions ($C_{LR}$ in Fig. 20) in the case of the Alderman-Grant coil. In this embodiment, such capacitance is attributed to two capacitors in a series arrangement formed between the vertical band parts and the separate wing parts. If the distances between the vertical band parts and the separate wing parts in this embodiment are equal to the distances between the wing portions in the Alderman-Grant coil, the capacitance component in this embodiment can be made equal to half the capacitance component in the Alderman-Grant coil. If the distances between the vertical band parts and the separate wing parts in this embodiment are larger than half of those in the Alderman-Grant coil, the overall capacitance component in this embodiment can be made smaller. Moreover, as with in the first example, the self resonance frequency can be increased with a decrease in the capacitance resulting from a decrease in the areas where the vertical band parts and the guard rings face each other.

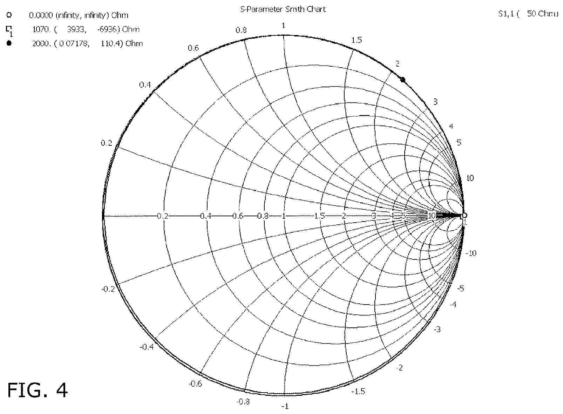

Fig. 4 shows the result of analysis of characteristics of the RF coil according to this embodiment performed by simulation. Fig. 4 is a Smith chart showing complex impedances at different frequencies in a case where a power supply port is attached to the RF coil. The self resonance frequency of an RF coil according to this embodiment designed for use with an NMR sample tube having a diameter of 5 mm was computed by the above-described method. The result was 1070 MHz. On the other hand, in the case of a conventional Alderman-Grant RF coil with two separated vertical bands having the same diameter design, the self resonance frequency obtained as the result was 842 MHz. Therefore, it was verified that the self resonance frequency was increased greatly by 228 MHz and that the RF coil according to the embodiment can be used at higher frequencies.

<Modification of First Embodiment>

In the first embodiment also, as with in the first example, the axial end portions of the vertical band parts 23, 24 may have tapered shapes (normal tapered shapes) as shown in Fig. 3B. In this case, the separate wing parts 25 to 28 may have shapes whose widths become larger toward the end (reverse tapered shapes), as shown in Fig. 3C. In Fig. 3C, the degree (or angle) of tapering of the vertical band parts 23, 24 and the degree of tapering of the separate wing parts 25 to 28 are the same so that the distances between them are constant. However, the degrees of tapering need not be necessarily the same. If they are designed to have different degrees of tapering, the distances between the vertical band parts and the separate wing parts may become either larger or smaller toward the ends.

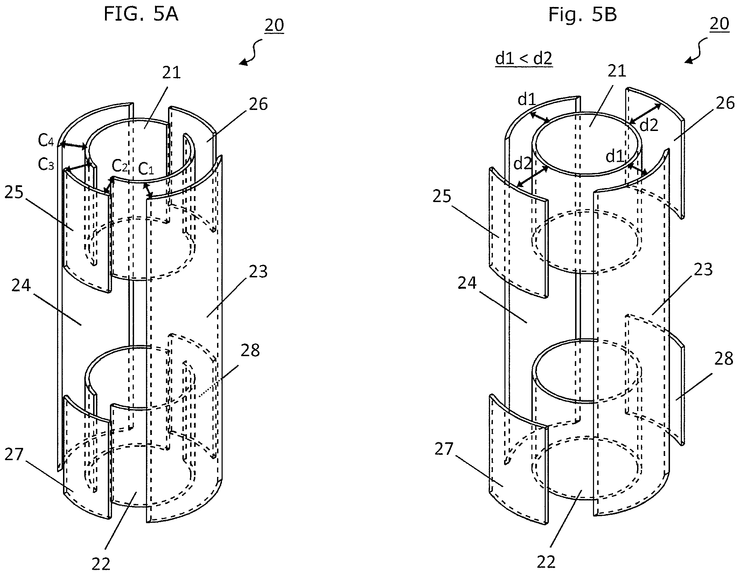

In the first embodiment, the guard rings 21, 22 may be divided as shown in Fig. 5A. In this case, the guard rings 21, 22 shall be divided at positions facing the separate wing parts. In this arrangement, the capacitance between the vertical band parts 23, 24 through one guard ring, e.g. the guard ring 21, is attributed to four capacitors (C1 to C4 in Fig. 5A) connected in series. Therefore, the capacitance component can be decreased further, and the self resonance frequency can be increased further. The number of divisions of the guard rings is not limited to two, but it may be more than two.

In the first embodiment, it is preferred that the distances d2 between the separate wing parts 25 to 28 and the guard rings 21, 22 be larger than the distances d1 between the vertical band parts 23, 24 and the guard rings 21, 22, as shown in Fig. 5B. With this arrangement, it is possible to reduce the capacitance between the separate wing parts 25 to 28 and the guard rings 21, 22, while reducing deterioration in the efficiency caused by an increase in the coil diameter.

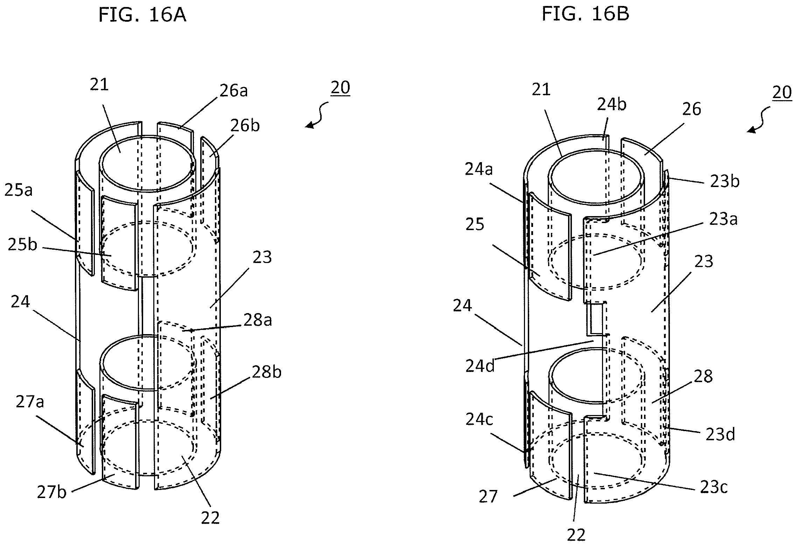

In the first embodiment, the number of separate wing parts provided between the vertical band parts is not limited to one, but it may be two or more. Fig. 16A shows an RF coil in which two separate wing parts are provided between the vertical band parts. This arrangement can be considered to be a modification of that in Fig. 5A. In this arrangement, the separate wing parts 25 to 28 are divided into two, namely into separate wing parts 25a to 28a and separate wing parts 25b to 28b. With this arrangement, the combined capacitance of the RF coil can be reduced. While in Fig. 16A, two separate wing parts are provided between the vertical band parts, three or more separate wing parts may be provided between the vertical band parts.

In the first embodiment, the vertical band parts may be provided with wing portions. Fig. 16B shows an RF coil having vertical band parts provided with wing portions, and separate wing parts separated from the vertical band parts provided between the wing portions. As shown in Fig. 16B, one vertical band part, e.g. the vertical band part 23, is provided with wing portions 23a, 23b projecting toward the vertical band part 24 (or more accurately speaking, toward the separate wing parts 25, 26) in the region near the upper guard ring 21. The wing portions 23a, 23b are continuous with the vertical band part 23. Similarly, the vertical band part 24 is provided with wing portions 24a, 24b extending toward the vertical band part 23 (or more accurately speaking, toward the separate wing parts 25, 26) in the region near the upper guard ring 21. The vertical band parts are also provided with wing portions in their lower end regions. In this arrangement also, the capacitance between the vertical band parts independent from the guard rings is equivalent to that in the case where, for example, two capacitors constituted respectively by the vertical band part 23 (wing portion 23a) and the separate wing part 25, and the separate wing part 25 and the vertical band part 24 (wing portion 24a) are connected in series. Therefore, the combined capacitance is decreased.

<Further Example: Asymmetric Wing Type>

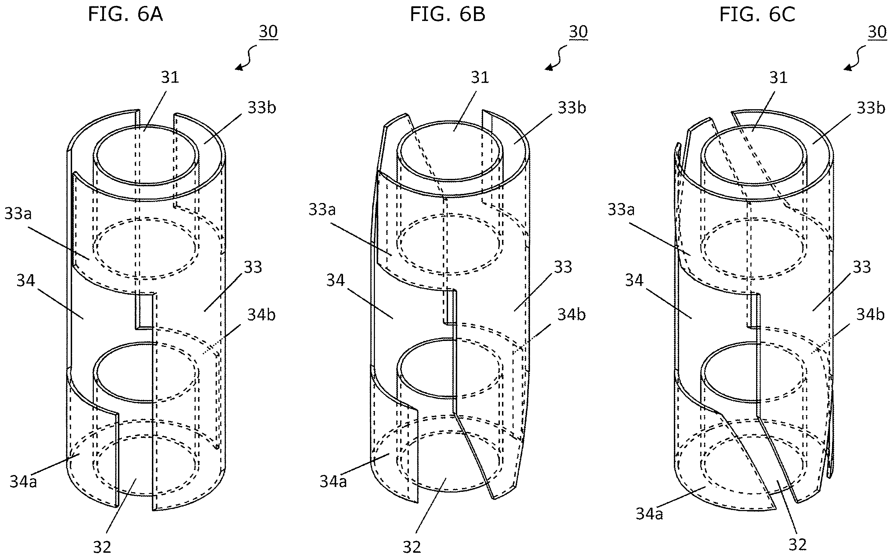

Fig. 6A shows the outer appearance of an RF coil 30 according to a further example. In this examples, the vertical band parts 33 and 34 in the RF coil according to the first example are augmented to have wing portions 33a, 33b and wing portions 34a, 34b respectively. More specifically, the vertical band part 33 is straight in the region near the lower guard ring 32 and has wing portions 33a and 33b extending toward the vertical band part 34 along the circumferential surface of the upper guard ring in the region near the upper guard ring 31. Similarly, the vertical band part 34 is straight in the region near the upper guard ring 31 and has wing portions 34a and 34b extending toward the vertical band part 33 along the circumferential surface of the lower guard ring in the region near the lower guard ring 32.

While in the case of the Alderman-Grant coil, the vertical band parts have wing portions projecting toward and opposed to each other, in this example, one of the vertical band parts is straight in shape and only the other of the vertical band parts has wing portions.

In the RF coil according to this example, as with in the Alderman-Grant coil, the combined capacitance through one guard ring, e.g. the guard ring 31, is attributed to a capacitor formed between the vertical band part 33 and the guard ring 31 and a capacitor formed between the guard ring 31 and the vertical band part 34 ($C_{LG}$ and $C_{RG}$ in Fig. 20), which are connected in series. If the area (capacitance) where the guard ring 31 and the vertical band part 34 face each other is sufficiently smaller than the other, the combined capacitance through the guard ring 31 has a value close to the capacitance of the capacitor formed between the guard ring 31 and the vertical band part 34. In this example, while the vertical band part 33 has wing portions in the upper region, the vertical band part 34 does not have wing portions in the upper region. Therefore, the capacitance between the guard ring 31 and the vertical band part 34 becomes smaller, and the combined capacitance through the guard ring 31 also becomes smaller.

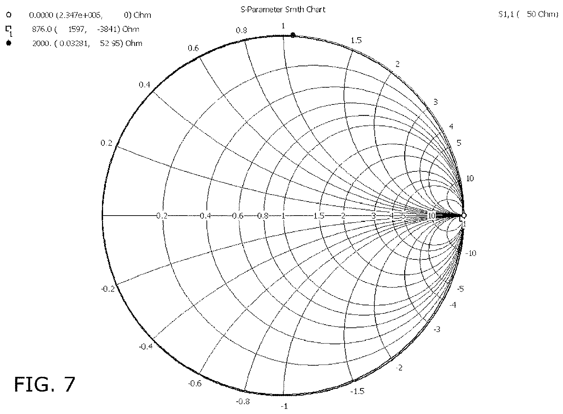

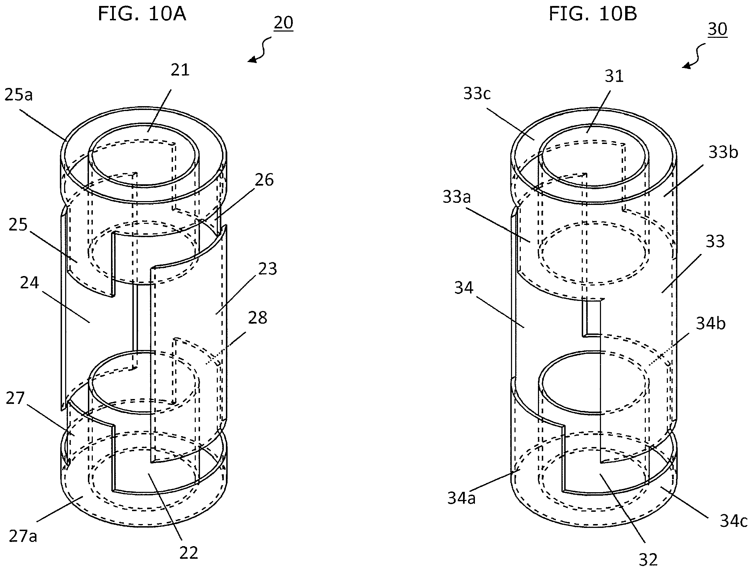

Fig. 7 shows the result of analysis of characteristics of the RF coil according to this example performed by simulation. Fig. 7 is a Smith chart showing complex impedances at different frequencies in a case where a power supply port is attached to the RF coil. The self resonance frequency of an RF coil according to this example designed for use with an NMR sample tube having a diameter of 5 mm was computed by the above-described method. The result was 876 MHz. On the other hand, in the case of a conventional Alderman-Grant RF coil with two separated vertical bands having the same diameter design, the self resonance frequency obtained as the result was 842 MHz. Therefore, it was verified that the self resonance frequency was increased a little by 34 MHz and that the RF coil according to the example can be used at higher frequencies. Then, the RF coil was modified to have vertical band parts that are shortened in their straight portions as shown in Fig. 10B, and simulation was performed again for this modified RF coil. The result was that the self resonance frequency was increased to 1148 MHz. This result revealed that the self resonance frequency of the RF coil can easily be increased by modifying the shape of the straight portions.

<Modification of Further Example>

The shape of the RF coil according to the further example can be modified in various manners.

In the further example also, as with in the first example and the first embodiment, the vertical band parts may have tapered shapes (normal tapered shapes) as shown in Fig. 6B. In this case, the straight end portion (not having a wing portion) of the vertical band part is tapered. In the case where the straight portion of the vertical band part is tapered, the wing portion may have a shape having a width that becomes larger toward the end (reverse tapered shape) as shown in Fig. 6C. In Fig. 6C, the degree (or angle) of tapering of the vertical band parts and the degree of tapering of the wing portions are the same so that the distances between them are constant. However, the degrees of tapering need not be necessarily the same. If they are designed to have different degrees of tapering, the distances between the vertical band parts and the separate wing parts may become either larger or smaller toward the ends.

The straight end portion of the vertical band may have a shape having a width that becomes larger toward the end (reverse tapered shape) instead of becoming smaller toward the end. In this case, the wing portion may have either a straight shape or a shape having a width that becomes smaller toward the end (normal tapered shape).

The vertical band parts and the wing portions may form an angle other than 90 degrees.

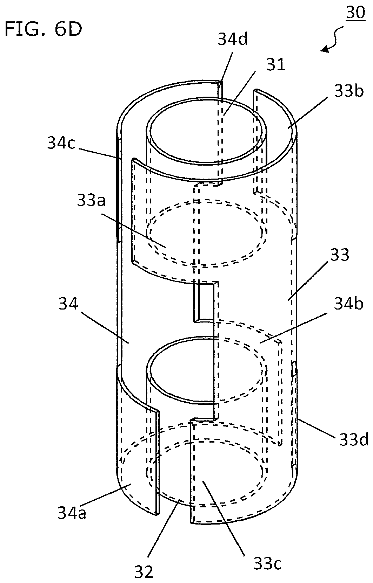

As shown in Fig. 6D, both of the two vertical band parts 33, 34 may be provided with wing portions. In the illustrated case, in the upper region, the lengths along the circumferential direction of the wing portions 34c, 34d of the vertical band part 34, which are opposed to the wing portions 33a, 33b of the vertical band part 33 respectively with respect to the circumferential direction, are shorter than the lengths along the circumferential direction of the wing portions 33a, 33b. In the lower region, similarly, the lengths along the circumferential direction of the wing portions 33c, 33d of the vertical band part 33, which are opposed to the wing portions 34a, 34b of the vertical band part 34 respectively with respect to the circumferential direction, are shorter than the lengths along the circumferential direction of the wing portions 34a, 34b. This modification may be regarded as a modification of the RF coil shown in Fig. 6A, in which the straight portions of the vertical bands are modified to have wing portions shorter than the wing portions of the opposed vertical bands in their end regions. This modification may also be regarded as a modification of the Alderman-Grant coil, in which the lengths along the circumferential direction of the two opposed wing portions are different. In the case shown in Fig. 6D, in the upper end region, the lengths along the circumferential direction of the wing portions of the vertical band part 33 are larger and the lengths along the circumferential direction of the wing portions of the vertical band part 34 are smaller. However, this is not essential. For example, the length along the circumferential direction of the wing portion 33a may be larger than the length along the circumferential direction of the wing portion 34c, and the length along the circumferential direction of the wing portion 34d may be larger than the length along the circumferential direction of the wing portion 33b. In other words, the point is that the wing portions opposed to each other have different lengths along the circumferential direction. In the RF coils having such a feature, capacitances between the vertical band parts and guard rings have a difference. In consequence, the combined capacitance between the vertical bands through a guard ring is smaller than that in the case in which the two capacitances equal to each other are connected in series like in the case of the Alderman-Grant coil. A portion (s) of the wing portion (s) and/or the vertical band part(s) may be cut away.

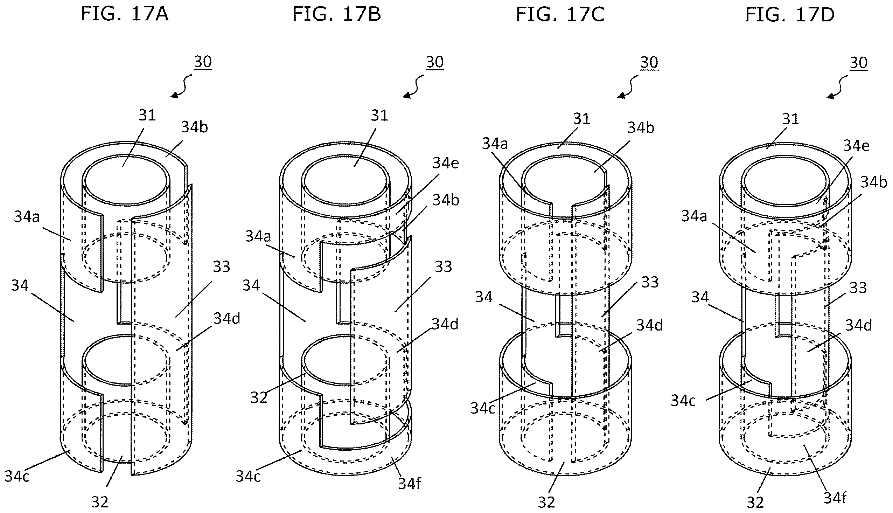

In the cases described with reference Figs. 6A to 6D, each vertical band part has wing portions on one end and has a straight shape on the other end. However, as shown in Fig. 17A, one vertical band part may be designed to be straight on both ends, and the other vertical band part may have wing portions on both ends. More specifically, while one vertical band part 33 is straight in both the upper and lower end regions, the other vertical band part 34 has wing portions 34a, 34b projecting toward the vertical band part 33 in the upper end region and wing portions 34c, 34d projecting toward the vertical band part 33 in the lower end region. The end portions of the straight vertical band part 33 may be tapered (in either normal tapering or reverse tapering), and the wing portions may also be tapered (in either normal tapering or reverse tapering).

<Other Modifications>

The above descriptions are directed merely to illustrative examples not forming embodiments of the present invention and to embodiments of the present invention, and the RF coil according to the present invention can be implemented in various ways.

(1. Combinations of Various Structures)

While in the above-described case, the vertical band parts have similar shapes in the regions near the two guard rings, the shapes may be different. For example, the shapes (and their modifications) described above may be employed in any combination. Specifically, the RF coil may have a straight type structure on one end and a separate wing type structure on the other end, a separate wing type structure on one end and an asymmetric wing type structure on the other end, or an asymmetric wing type structure on one end and a straight type structure on the other end.

(2. Modifications of Structure at One End)

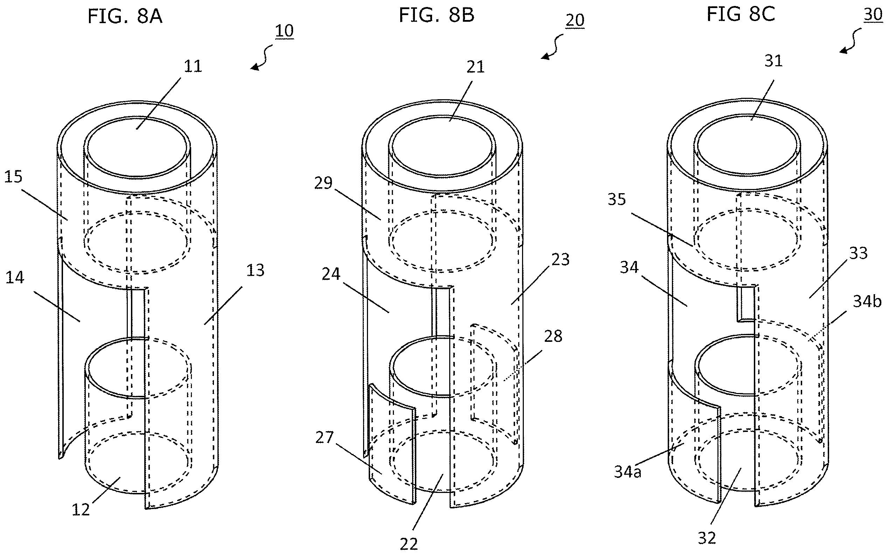

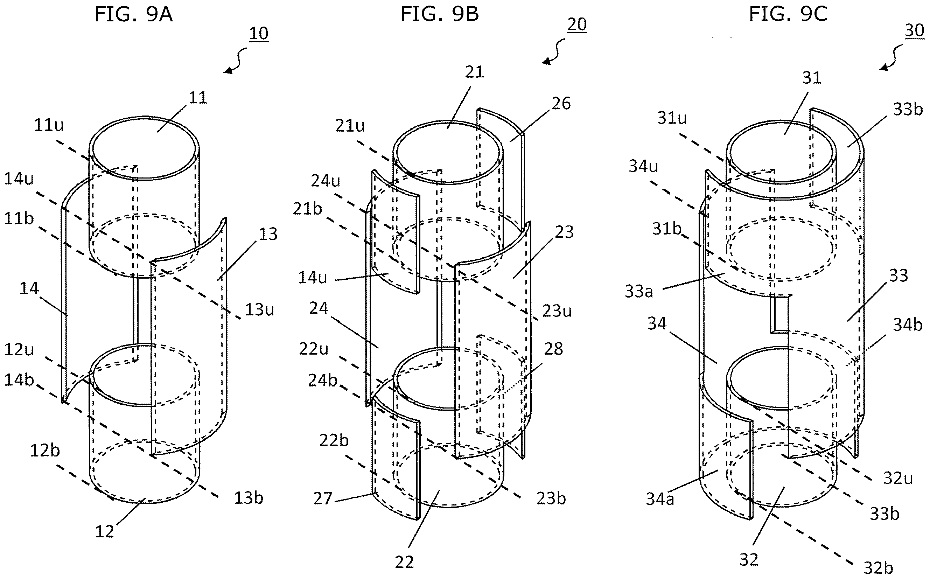

The shape in the region near one guard ring may be modified to be different from those described in the foregoing. For example, a connecting part may be provided between the two vertical band parts to face the circumferential surface of the guard ring so that the two vertical band parts are connected by the connection part to cover all the circumference of the guard ring. This structure will be referred to as the connection type structure. Then, the RF coil may have the straight type structure on one end and the connection type structure on the other end (Fig. 8A), the separate wing type structure on one end and the connection type structure on the other end (Fig. 8B), or the asymmetric wing type structure on one end and the connection type structure on the other end (Fig. 8C). While Figs. 8A to 8C show exemplary cases in which basic structures of the straight type, separate wing type and asymmetric wing type (Figs. 1A, 3A and 6A) are employed in combination with the connection type structure, the modifications of those types (Figs. 1B, 3B, 3C, 5A, 5B, 6B and 6C) and the types that will be described in the following (Figs. 9A to 9C, 10A, 10B, and 11A to 11C etc.) may be employed in combination with the connection type.

(3. Shortened Vertical Band Part)

While in the above-described case, the upper ends of the vertical band parts and the upper end of the upper guard ring are at the same level and the lower ends of the vertical band parts and the lower end of the lower guard ring are at the same level, the length of the vertical bands may be shorter. In particular, in cases where the vertical band parts have straight shapes (including tapered shapes) in the end region, it is preferred that ends of the vertical band parts be at a level different from the end of the guard rings so as to make the capacitance smaller. Modifications to the straight type, separate wing type, and asymmetric wing type are shown in Figs. 9A to 9C.

Fig. 9A shows a case in which vertical band parts in the straight type are shortened. Specifically, the levels 13u, 14u of the upper ends of the vertical band parts 13, 14 are lower than the level 11u of the upper end of the upper guard ring 11. Similarly, the levels 13b, 14b of the lower ends of the vertical band parts 13, 14 are higher than the level 12b of the lower end of the lower guard ring 12. Although the levels 13u, 14u of the upper ends of the vertical band parts 13, 14 are higher than the level 11b of the lower end of the guard ring 11 in Fig. 9A, this is not essential. The levels 13u, 14u of the upper ends of the vertical band parts 13, 14 may be lower than the level 11b of the lower end of the upper guard ring 11. Similarly, the levels 13b, 14b of the lower ends of the vertical band parts 13, 14 may be higher than the level 12u of the upper end of the lower guard ring 12. With this arrangement, the areas where the vertical band parts and the guard rings face each other can be decreased, and the capacitance component can further be decreased.

Fig. 9B shows a case in which vertical band parts in the separate wing type are shortened. The construction is basically the same as that in Fig. 9A, and it will not be described in detail. Fig. 9C shows a case in which the straight end portions (i.e. the end portions not provided with wing portions) of vertical band parts in the asymmetric wing type are shortened with respect to the up-down direction. The level of the wing side end is the same as the level of the end of the guard ring. However, the level of the end of the wing need not necessarily be the same as the level of the end of the guard ring.

As has already been described in the description of the result of simulation of the further example, the self resonance frequency of the RF coil can easily be adjusted by adjusting the length of the vertical band parts. While the Alderman-Grant coil does not have a large margin for adjustment of the coil shape in view of influences on the evenness of the static magnetic field and other factors, the RF coil according to the present invention has an advantageously large margin for this adjustment.

(4. Connection of Wing Part)

In cases where vertical band parts in the separate wing type are shortened, the wing parts may be connected with each other utilizing a left space (space around the guard ring in which the vertical band parts are absent) as shown in Fig. 10A. In Fig. 10A, a connecting ring 25a that connects separate wing parts 25, 26 is provided to surround the upper end portion of a guard ring 21. Similarly, separate wing portions 27, 28 are connected by a connection ring 27a provided in such a way as to surround the lower end portion of a lower guard ring 22. The connection rings facilitate fixation of the separate wing parts.

In cases where vertical band parts in the asymmetric wing type are shortened, the wing parts may be connected with each other utilizing a left space as shown in Fig. 10B, as with in the case described above. In Fig. 10B, the vertical band part 33 has wing portions 33a and 33b in the region near the upper guard ring 31, and a connecting portion 33c that connects the wing portions 33a and 33b is provided in a left space. Similarly, the vertical band part 34 has a connecting portion 34c that is provided around the lower guard ring 32 to connect wing portions 34a and 34b in the region near the lower guard ring 32. The connection rings 33c, 34c facilitate fixation of the wing portions.

In the modification of the asymmetric type shown in Fig. 17A also, the wing parts may be connected as shown in Fig. 17B. In this case, a vertical band part 33 is of a short straight type, in which the upper and lower ends are located inside the upper and lower ends of the guard rings. Another vertical band part 34 has wing portions 34a, 34b on its upper end and wing portions 34c, 34d on its lower end. A connecting portion 34e that connects the wing portions 34a, 34b is provided around the guard ring 31 utilizing a left space, and a connecting portion 34f that connects the wing portions 34c, 34d is provided around the guard ring 32.

(5. Modifications of End Portion of Vertical Band Part)

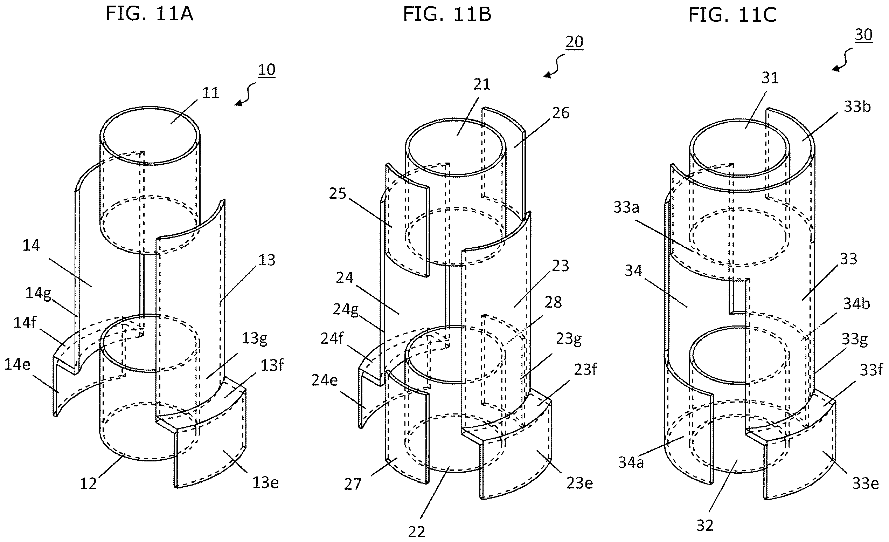

It is preferred that the distances between straight end portions of vertical band parts and a guard ring be larger. In a straight type RF coil shown in Fig. 11A, the end portions 13e, 14e of the vertical band parts 13, 14 on the lower guard ring 12 side are farther from the guard ring 12 than the body portions 13g, 14g of the vertical band parts13, 14. The end portions 13e, 14e are parallel with the body portions 13g, 14g. The vertical band parts 13, 14 also have connecting portions 13f, 14f that connect the body portions 13g, 14g and the end portions 13e, 14e. Although the connecting portions 13f, 14f are illustrated to be perpendicular to the body portions 13g, 14g and the end portions 13e, 14e in Fig. 11A, they need not necessarily be perpendicular to each other. Moreover, their edges may be rounded. Such end portions allow a power supply port to be attached at the lower end and enable a reduction of the capacitance between the vertical band parts and the guard ring.

Figs. 11B and 11C show cases in which similar modifications are made respectively to a separate wing type coil and an asymmetric wing type coil. In the separate wing type shown in Fig, 11B, the distances between the vertical band parts 23, 24 and the lower guard ring 22 becomes larger in the end portions 23e, 24e near the lower guard ring 22. In the asymmetric wing type shown in Fig. 11C, the distance between the vertical band part having a straight shape in the region near the lower guard ring and the lower guard ring 32 becomes larger in the end portion 33e.

As shown in Figs. 11A to 11C, in cases where the distance between the end portion of a vertical band part and the guard ring is larger, a connecting portion that connects wing portions as shown in Figs. 10A and 10B may be provided in this region.

(6. Modifications of Shape of Guard Ring and Shape of Vertical Band Part)

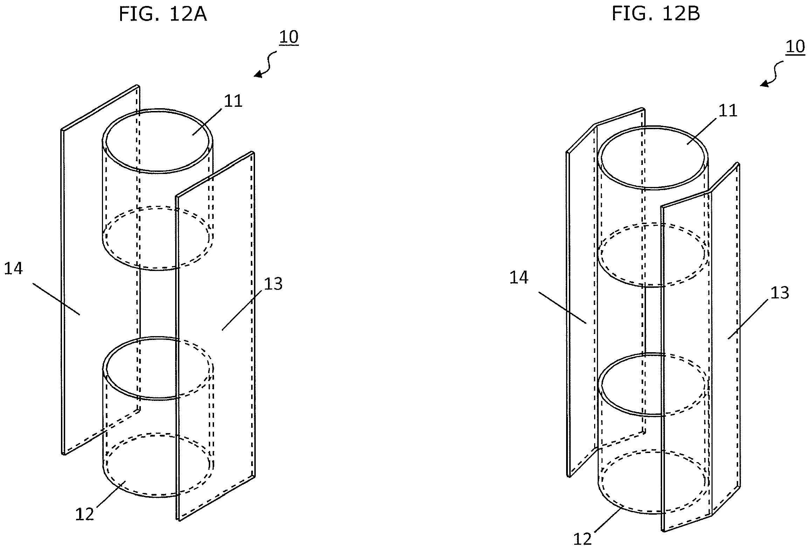

While in the above-described cases, the guard rings have cylindrical shapes, they may have elliptic cylindrical shapes or polygonal cylindrical shapes (i.e. hollow polygonal prism shapes). The shapes of the vertical band parts are also not limited to segments of a cylinder, but they may be flat plate-like shapes or shapes constituted by several flat plates joined together. Fig. 12A shows an illustrative case in which vertical band parts each having a flat plate-like shape are used in a straight type RF coil. Fig. 12B shows an illustrative case in which vertical band parts each having a shape like two flat plates joined together are used in a straight type RF coil.

The shapes of the guard rings and the shapes of the vertical band parts described here may be employed in any combination. While modifications to a straight RF coil are shown in Figs. 12A and 12B, similar modification can also be made to coils of other types.

(7. Modifications of Positions of Guard Ring and Vertical Band Part)

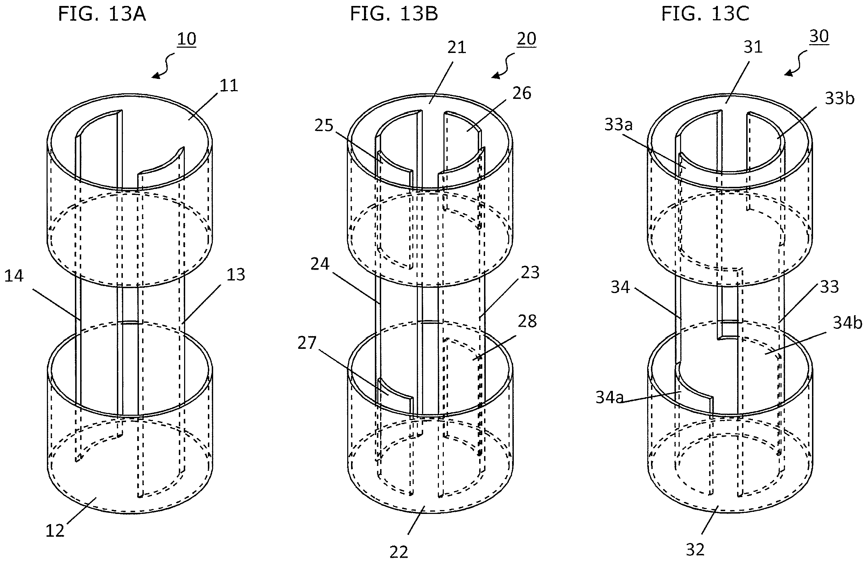

While in the above-described cases, the vertical band parts are arranged outside the guard rings, the vertical band parts may be arranged inside the guard rings. Figs. 13A to 13C show exemplary RF coils of the straight type, separate wing type, and asymmetric wing type respectively in which the vertical band parts are arranged inside the guard rings. Such arrangements are preferable in cases where a power supply ports are provided at the upper and lower ends of the vertical band parts or at the upper and lower ends of the guard rings.

Figs. 17C and 17D show modifications in which the vertical band parts are arranged inside the guard rings in the RF coils shown in Figs. 17A and 17B respectively.

(8. Addition of Slit)

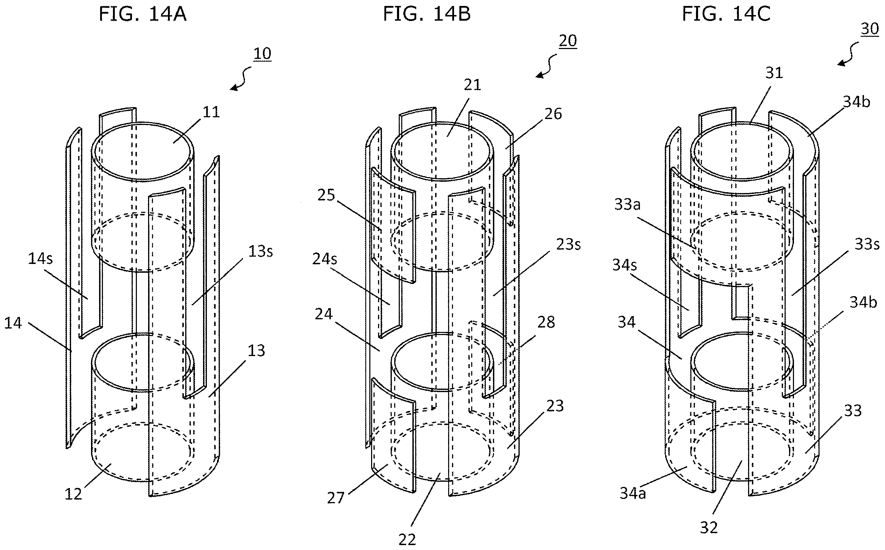

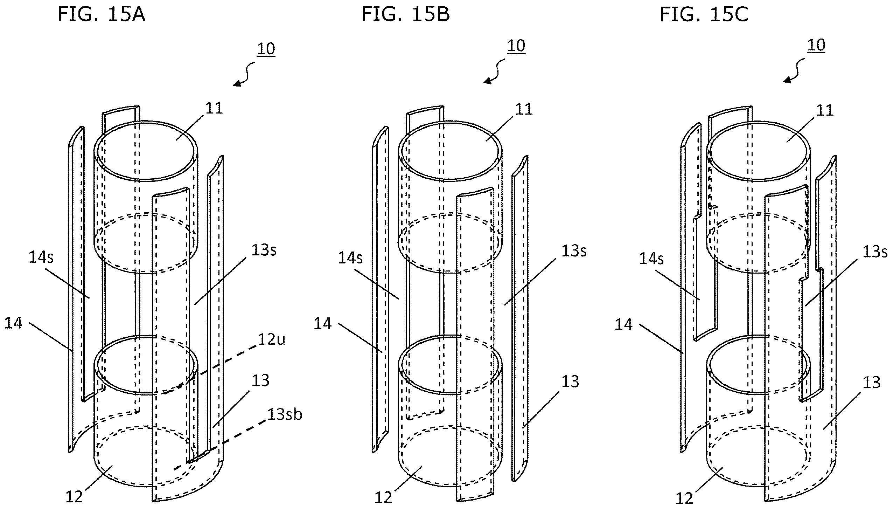

The vertical band parts may have slits in the window region (region in which the guard rings do not exist). This allows the use of another RF coil to apply a magnetic field of a different frequency. When magnetic fields of multiple frequencies are to be applied, they cannot be generated by one RF coil, and an RF coil having slits and another RF coil oriented 90 degrees thereto that is mounted outside the RF coil having slits are used. A high frequency magnetic field generated by the outer RF coil is applied to the measurement sample through the slits. So long as slits are provided in the window region, the slits may have any shape. Examples are shown in Figs. 14A to 14C. Figs. 14A to 14C show exemplary RF coils of the straight type, separate wing type, and asymmetric wing type respectively in which the vertical band parts have slits. In the illustrated RF coils, the vertical band parts have slits extending from the upper ends thereof to the window region. The shape of the slits may be modified in various ways. For instance, as shown in Fig. 15A, the level 13sb of the lower ends of the slits may be lower than the level 12u of the upper end of the lower guard ring 12. Alternatively, as shown in Fig. 15B, the slits may further be extended to divide each vertical part into two. Alternatively, as shown in Fig. 15C, Each slit may have different widths in the region near the guard ring and in the window region so that the slit has a broader width in the window region. Although Figs. 15A to 15C show modifications to a straight type RF coil, similar modifications can be made to a separate wing type or asymmetric wing type RF coils.

(9. Others)

In the foregoing, there have been described, by way of example, RF coils used to apply a high frequency magnetic field higher than 1.03 GHz for use with a sample tube having a diameter of 5 mm (the RF coils having inner diameters of 5.4 to 10 mm). The frequency of the magnetic field generated by the RF coil according to the present invention may either be higher or lower than 1.03 GHz, and the diameter of the RF coil may be larger or smaller than the above-mentioned range. Employing the shape of the RF coil according to the present invention without changing the other conditions can increase the self resonance frequency of the RF coil without a decrease in the coil diameter or deterioration in the magnetic field generation efficiency. In consequence, it is possible to transmit or receive a high frequency magnetic field of a higher frequency without deterioration in the reception sensitivity when the static magnetic field intensity is increased.

While in the above-described cases, induction of nuclear magnetic resonance (transmission of high frequency magnetic field) and detection of nuclear magnetic resonance (reception of NMR signals) are performed using one RF coil, transmission and reception may be performed using different coils. The RF coil according to the present invention can be used as either a coil for induction or a coil for detection as well as a coil for both induction and detection.

While in the above description, a solution NMR apparatus has been described by way of example, the RF coil according to the present invention may also be applied to a solid NMR apparatus. The MRI apparatus, which obtains information about the interior of an organism as an image using nuclear magnetic resonance, is based on the same principle as the NMR apparatus, though they are different in the size of the apparatus and in the intensity of the magnetic field applied by the apparatus. Therefore, the RF coil according to the present invention can also be used in an MRI apparatus. Although the intensity of the magnetic field used in MRI apparatuses is several Tesla, the self resonance frequency of the RF coil is low due to its large diameter. When the static field intensity is to be increased, the RF coil according to the present invention is useful in increasing the self resonance frequency without reducing the size of the coil.

While in the above-described cases, no chip capacitor is provided between the vertical band parts, the vertical band parts may be connected by a chip capacitor as described in non-patent document 1. The use of a chip capacitor helps the RF coil to maintain its shape and can make up for insufficient capacitance when needed.

The modifications described above may be adopted in combination with any of the examples and embodiments or two or more modifications may be adopted in combination, unless they are not technically incompatible. The shapes or structures of the vertical band parts and the separate wing parts in the region near the upper and lower guard rings in the embodiments and modifications described in the foregoing may be adopted in any combination. Specifically, referring to the vertical band parts, desired structures may be employed in the upper and lower end portions of the two vertical band parts (four end portions in all).

[DESCRIPTION OF THE REFERENCE SIGNS]

10, 20, 30: RF coil
11, 12, 21, 22, 31, 32: guard ring
13, 14, 23, 24, 33, 34: vertical band part
25, 26, 27, 28: separate wing part
33a, 33b, 34a, 34b: wing portion

## Claims

**1.** An Alderman-Grant type or saddle-type RF coil (20) used to induce or detect nuclear magnetic resonance comprising:

two guard rings (21, 22) having substantially cylindrical, elliptic cylindrical, or polygonal cylindrical outer shapes and arranged coaxially with a space therebetween along an axis aligned with the axial direction of said cylindrical, elliptic cylindrical, or polygonal cylindrical shapes;
first and second vertical band parts (23, 24), each having a substantially straight shape and extending in said axial direction from one guard ring to the other guard ring, the first and second vertical band parts being opposed to each other with respect to said axis and each running along the outer circumference of said guard rings (21, 22),
**characterized in that** the RF coil has the following structure at the position of at least one of the guard rings:

a first and a second separate wing part (25 - 28) is provided separately from said first and second vertical band parts (23, 24) at a position facing the circumferential surface of said at least one of the guard rings (21, 22), each of said first and second separate wing parts being located in-between said first and second vertical band parts (23, 24) in a manner such that the first and second separate wing parts are mutually opposite with respect to said axis.

**2.** An RF coil according to claim 1, wherein said two guard rings are divided at a position facing said separate wing part.

**3.** An RF coil according to claim 1 or 2, wherein said first and said second is provided at a position farther from said guard rings than the positions of said first and second vertical band parts.

**4.** An RF coil according to any one of claims 1 to 3, wherein the length of said first and second vertical band parts along the axial direction is shorter than the distance between the upper end and the lower end of said two guard rings, so that the guard rings have an upper end portion or lower end portion that does not face said first or second vertical band part.

**5.** An RF coil according to claim 4, wherein a connecting portion that connects said separate wing part is provided around the upper end portion or lower end portion of the guard rings that does not face said first or second vertical band part, at a position facing the outer circumferential surface of one of said guard rings.

**6.** An RF coil according to any one of claims 1 to 5, wherein a plurality of separate wing parts separated from said first and second vertical band parts and separated from each other are provided at a position facing the circumferential surface of one of said guard rings between said first and second vertical band parts.

**7.** An RF coil according to any one of claims 1 to 6, wherein each of said first and second vertical band parts has a wing portion projecting toward the other vertical band part in a region near the guard rings.

**8.** An RF coil according to any one of claims 1 to 7, wherein the distances between the first and second vertical band parts and said guard rings are larger in an end region.

**9.** An RF coil according to any one of claims 1 to 8, wherein the cross sections of said first and second vertical band parts on a plane perpendicular to said axis have circular arc shapes.

**10.** An RF coil according to any one of claims 1 to 8, wherein said first and second vertical band parts have shapes constituted by a plurality of flat plates joined together.

**11.** An RF coil according to any one of claims 1 to 10, wherein said first and second vertical band parts have a slit provided in a portion not facing the circumferential surface of said guard rings.

## Patentansprüche

**1.** Eine HF-Spule (20) vom Alderman-Grant-Typ oder Satteltyp, benutzt zum Induzieren oder Erfassen von Kernspinresonanz, aufweisend:

zwei Schutzringe (21, 22), aufweisend im Wesentlichen zylindrische, elliptisch zylindrische oder polygonale zylindrische Formen und koaxial angeordnet mit einem Raum dazwischen entlang einer mit der Axialrichtung der zylindrischen, elliptisch zylindrischen oder polygonal zylindrischen Formen ausgerichteten Achse;
erste und zweite vertikale Bandteile (23, 24), die jeweils eine im Wesentlichen gerade Form aufweisen und sich in der Axialrichtung von einem Schutzring zum anderen Schutzring erstrecken, wobei die ersten und zweiten vertikalen Bandteile bezogen auf die Achse einander gegenüberliegen und jeder entlang dem äußeren Umfang der Schutzringe (21, 22) laufen,
**dadurch gekennzeichnet, dass** die HF-Spule die folgende Struktur bei der Position von mindestens einem der Schutzringe aufweist:

einen ersten und einen zweiten Flügelteil (25-28), der getrennt von den ersten und zweiten vertikalen Bandteilen (23, 24) in einer zur Umfangsfläche von mindestens einem der Schutzringe (21, 22) gerichteten Position bereitgestellt ist, wobei jeder der ersten und zweiten Flügelteile auf solche Weise zwischen den ersten und zweiten vertikalen Bandteilen (23, 24) angeordnet ist, dass die ersten und zweiten getrennten Flügelteile bezogen auf die Achse einander gegenüber liegen.

**2.** HF-Spule nach Anspruch 1, wobei die zwei Schutzringe in einer Position geteilt sind, in der sie zum getrennten Flügelteil gerichtet sind.

**3.** HF-Spule nach einem der Ansprüche 1 oder 2, wobei die ersten und zweiten Flügelteile in einer Position bereitgestellt sind, die weiter von den Schutzringen entfernt ist als die Positionen der ersten und zweiten vertikalen Bandteile.

**4.** HF-Spule nach einem der Ansprüche 1 bis 3, wobei die Länge der ersten und zweiten vertikalen Bandteile entlang der Axialrichtung kürzer ist als der Abstand zwischen dem oberen Ende und dem unteren Ende der zwei Schutzringe, so dass die Schutzringe einen oberen Endabschnitt oder einen unteren Endabschnitt aufweisen, der nicht zum ersten oder zweiten vertikalen Bandteil gerichtet ist.

**5.** HF-Spule nach Anspruch 4, wobei ein Verbindungsabschnitt, der den getrennten Flügelteil verbindet, um den oberen Endabschnitt oder den unteren Endabschnitt der Schutzringe, die nicht zum ersten oder zweiten vertikalen Bandteil gerichtet sind, in einer Position bereitgestellt ist, die zur äußeren Umfangsfläche von einem der Schutzringe gerichtet ist.

**6.** HF-Spule nach einem der Ansprüche 1 bis 5, wobei mehrere der getrennten Flügelteile, die von den ersten und zweiten vertikalen Bandteilen getrennt sind, und die voneinander getrennt sind, in einer Position bereitgestellt sind, die zur Umfangsfläche eines der Schutzringe zwischen den ersten und zweiten vertikalen Bandteilen gerichtet ist.

**7.** HF-Spule nach einem der Ansprüche 1 bis 6, wobei jeder der ersten und zweiten vertikalen Bandteile einen Flügelabschnitt aufweist, der zum anderen vertikalen Bandteil in einem Bereich nahe der Schutzringe vorsteht.

**8.** HF-Spule nach einem der Ansprüche 1 bis 7, wobei die Abstände zwischen den ersten und zweiten vertikalen Bandteilen und den Schutzringen größer in einem Endbereich sind.

**9.** HF-Spule nach einem der Ansprüche 1 bis 8, wobei die Querschnitte der ersten und zweiten vertikalen Bandteile in einer zur Achse senkrechten Ebene eine Kreisbogenform aufweisen.

**10.** HF-Spule nach einem der Ansprüche 1 bis 8, wobei die ersten und zweiten vertikalen Bandteile Formen aufweisen, die durch mehrere ebene, zusammengefügte Platten gebildet werden.

**11.** HF-Spule nach einem der Ansprüche 1 bis 10, wobei die ersten und zweiten vertikalen Bandteile in einem nicht zur Umfangsfläche der Schutzringe gerichteten Abschnitt einen Schlitz aufweisen.

## Revendications

**1.** Bobine de RF (radiofréquence) (20) de type Alderman-Grant ou en forme de selle utilisée pour induire ou détecter la résonance magnétique comprenant :

deux anneaux de garde (21, 22) ayant des formes externes cylindres, cylindriques elliptiques ou cylindriques polygonales et agencés de manière coaxiale avec un espace entre eux le long d'un axe aligné avec la direction axiale desdites formes cylindriques, cylindriques elliptiques ou cylindriques polygonales ;
des première et seconde parties de bande verticales (23, 24), ayant chacune une forme sensiblement droite et s'étendant dans ladite direction axiale d'un anneau de garde à l'autre anneau de garde, les première et seconde parties de bande verticales étant opposées entre elles par rapport audit axe et s'étendant chacune le long de la circonférence externe desdits anneaux de garde (21, 22),
**caractérisée en ce que** la bobine de RF a la structure suivante dans la position d'au moins l'un des anneaux de garde :

une première et une seconde partie d'aile séparée (25 - 28) sont prévues séparément desdites première et seconde parties de bande verticales (23, 24) dans une position faisant face à la surface circonférentielle dudit au moins un des anneaux de garde (21, 22), chacune desdites première et seconde parties d'aile séparées étant positionnée entre lesdites première et seconde parties de bande verticales (23, 24) de sorte que les première et seconde parties d'aile séparées sont mutuellement opposées par rapport audit axe.

2. Bobine de RF selon la revendication 1, dans laquelle lesdits deux anneaux de garde sont divisés dans une position faisant face à ladite partie d'aile séparée.

3. Bobine de RF selon la revendication 1 ou 2, dans laquelle lesdites première et seconde parties d'aile séparées sont prévues dans une position plus éloignée desdits anneaux de garde que les positions desdites première et seconde parties de bande verticales.

4. Bobine de RF selon l'une quelconque des revendications 1 à 3, dans laquelle la longueur desdites première et seconde parties verticales le long de la direction axiale est plus courte que la distance entre l'extrémité supérieure et l'extrémité inférieure desdits deux anneaux de garde, de sorte que les anneaux de garde ont une partie d'extrémité supérieure ou une partie d'extrémité inférieure qui ne fait pas face à ladite première ou seconde partie de bande verticale.

5. Bobine de RF selon la revendication 4, dans laquelle une partie de raccordement qui raccorde ladite partie d'aile séparée est prévue autour de la partie d'extrémité supérieure ou de la partie d'extrémité inférieure desdits anneaux de garde qui ne fait pas face à ladite première ou seconde partie de bande verticale, dans une position faisant face à la surface circonférentielle externe de l'un desdits anneaux de garde.

6. Bobine de RF selon l'une quelconque des revendications 1 à 5, dans laquelle une pluralité de parties d'aile séparées, séparées desdites première et seconde parties de bande verticales et séparées l'une de l'autre, sont prévues dans une position faisant face à la surface circonférentielle de l'un desdits anneaux de garde entre lesdites première et seconde parties de bande verticales.

7. Bobine de RF selon l'une quelconque des revendications 1 à 6, dans laquelle chacune desdites première et seconde parties de bande verticales a une partie d'aile faisant saillie vers l'autre partie de bande verticale dans une région à proximité des anneaux de garde.

8. Bobine de RF selon l'une quelconque des revendications 1 à 7, dans laquelle les distances entre les première et seconde parties de bande verticales et lesdits anneaux de garde sont plus importantes dans une région d'extrémité.

9. Bobine de RF selon l'une quelconque des revendications 1 à 8, dans laquelle les sections transversales desdites première et seconde parties de bande verticales sur un plan perpendiculaire audit axe ont des formes d'arc circulaires.

10. Bobine de RF selon l'une quelconque des revendications 1 à 8, dans laquelle lesdites première et seconde parties de bande verticales ont des formes constituées par une pluralité de plaques plates reliées ensemble.

11. Bobine de RF selon l'une quelconque des revendications 1 à 10, dans laquelle lesdites première et seconde bandes verticales ont une fente prévue dans une partie ne faisant pas face à la surface circonférentielle desdits anneaux de garde.

10
11
13u
13
13b
12
14u
14
14b

FIG. 1B

10
11
13
12
14

FIG. 1A

0.0000 (infinity, infinity) Ohm
1066. (1.523e+004, -571.8) Ohm
2000. ( 0.07535, 111.2) Ohm
S-Parameter Smith Chart
S1,1 ( 50 Ohm)

FIG. 2

20
26
23
28
22
21
25
24
27

FIG. 3A

FIG. 3B

Fig. 3C

S-Parameter Smith Chart
0.0000 (infinity, infinity) Ohm
1070. ( 3933, -6936) Ohm
2000. ( 0 07178, 110.4) Ohm
S1,1 ( 50 Ohm)
0.2
0.4
0.6
0.8
1
1.5
2
3
4
5
10
-0.2
-0.4
-0.6
-0.8
-1
-1.5
-2
-3
-4
-5
-10

FIG. 4

20
26
28
23
d2
d1
21
d1
d2
d1 < d2
22
25
24
27
Fig. 5B

20
26
23
28
21
C1
C2
C4
C3
22
25
24
27
FIG. 5A

FIG. 6C
30
33b
31
33
34b
32
33a
34
34a
FIG. 6B
30
33b
31
33
34b
32
33a
34
34a
FIG. 6A
30
33b
31
33
34b
32
33a
34
34a

FIG. 6D
30
34d
31
33b
34c
33a
33
34
34b
33d
34a
32
33c

S-Parameter Smith Chart
S1,1 ( 50 Ohm)
0.0000 (2.347e+006, 0) Ohm
876.0 ( 1597, -3841) Ohm
2000. ( 0.03281, 52 95) Ohm
0.2
0.4
0.6
0.8
1
1.5
2
3
4
5
10
-0.2
-0.4
-0.6
-0.8
-1
-1.5
-2
-3
-4
-5
-10

FIG. 7

FIG 8C
30
31
33
34b
32
34a
34
35
FIG. 8B
20
21
23
28
22
27
24
29
FIG. 8A
10
11
13
12
14
15

FIG. 9A
10
11
13
13u
13b
12
11u
14u
11b
14
12u
14b
12b
FIG. 9B
20
26
21
23
23u
28
23b
22
21u
24u
21b
14u
24
22u
24b
22b
27
FIG. 9C
30
33b
31
33
34b
32u
33b
32b
32
31u
34u
31b
33a
34
34a

FIG. 10B
30
31
32
33
33a
33b
33c
34
34a
34b
34c

FIG. 10A
20
21
22
23
24
25
25a
26
27
27a
28

FIG. 11A
10
11
13
13g
13f
13e
12
14
14g
14f
14e
FIG. 11B
20
26
21
23
28
23g
23f
23e
22
25
24
24g
24f
24e
27
FIG. 11C
30
33b
31
33
34b
33g
33f
33e
32
33a
34
34a

FIG. 12B
10
11
13
12
14

FIG. 12A
10
11
13
12
14

FIG. 13C
30
31
33b
33
34b
32
33a
34
34a
FIG. 13B
20
21
26
23
28
22
25
24
27
FIG. 13A
10
11
13
12
14

FIG. 14C
30
31
32
33
33a
33s
34
34a
34b
34s
FIG. 14B
20
21
22
23
23s
24
24s
25
26
27
28
FIG. 14A
10
11
12
13
13s
14
14s

FIG. 15A
10
11
13s
12u
13
13sb
14s
14
12
FIG. 15B
10
11
13s
13
14s
14
12
FIG. 15C
10
11
13s
13
14s
14
12

FIG. 16B

20
26
23b
23a
23
28
23d
23c
24b
21
22
24a
25
24
24d
24c
27

FIG. 16A

20
26a
26b
23
28a
28b
22
21
25a
25b
24
27a
27b

FIG. 17A
FIG. 17B
FIG. 17C
FIG. 17D
30
31
32
33
34
34a
34b
34c
34d
34e
34f

FIG. 18A

104
101
102
100
103

FIG. 18B

105
$B_0(t)$
106
RF coil
$B_1(t)$

FIG. 19A

ALDERMAN-GRANT TYPE

FIG. 19B

SADDLE TYPE

PRIOR ART

$L_R$
$L_L$
$C_{RG}$
$C_{LG}$
$C_{LR}$


FIG. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4641097 A
- US 2006158188 A
- JP 61166507 A
- US 7106063 B
- US 2001033166 A
- US 6121776 A
- JP H02195938 B
- US 5245285 A


### Non-patent literature cited in the description


- **ALDERMAN DW ; GRANT DM.** Efficient Decoupler Coil Design which Reduces Heating in Conductive Samples in Superconducting Spectrometers. *Journal of Magnetic Resonance,* 1979, vol. 36, 447-451
- **GERALD J. KOST.** A Cylindrical-Window NMR Probe with Extended Tuning Range for Studies of the Developing Heart. *Journal of Magnetic Resonance,* 1989, vol. 82, 238-252